(19) Europäisches Patentamt / European Patent Office / Office européen des brevets

(11) **EP 3 916 267 A1**

(12) **EUROPEAN PATENT APPLICATION**

(43) Date of publication:
01.12.2021 Bulletin 2021/48

(51) Int Cl.:
*F16H 55/08* (2006.01)          *G06F 30/17* (2020.01)
*F16H 57/00* (2012.01)          *G01M 13/021* (2019.01)
*G01M 13/028* (2019.01)

(21) Application number: 21172235.0

(22) Date of filing: 05.05.2021

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 28.05.2020 JP 2020093065

(71) Applicant: **Mitsubishi Heavy Industries, Ltd.**
**Chiyoda-ku,**
**Tokyo 1008332 (JP)**

(72) Inventors:
• **NISHIURA, Kensuke**
**Tokyo, 1008332 (JP)**
• **SHODA, Katsuhiko**
**Tokyo, 1008332 (JP)**
• **OTAKA, Kazuma**
**Tokyo, 1008332 (JP)**

(74) Representative: **Studio Torta S.p.A.**
**Via Viotti, 9**
**10121 Torino (IT)**

(54) **TOOTH SURFACE SHAPE DESIGN SUPPORT DEVICE, GEAR MACHINING SYSTEM, AND TOOTH SURFACE SHAPE DESIGN SUPPORT PROGRAM**

(57) Problem
To provide a tooth surface shape design support device capable of efficiently evaluating a complicated tooth surface shape of a gear with a small amount of calculation.

Solving Means
A tooth surface shape design support device for supporting design of a tooth surface shape of a gear includes a principal component shape data acquisition unit configured to acquire a plurality of principal component shape data obtained by performing principal component analysis on a tooth surface shape sample data group including a plurality of tooth surface shape sample data indicating samples of the tooth surface shape, and a tooth surface shape evaluation unit configured to evaluate a tooth surface shape defined by using the plurality of principal component shape data acquired by the principal component shape data acquisition unit.

FIG. 3

**Description**

Technical Field

The present disclosure relates to a tooth surface shape design support device, a gear machining system, and a tooth surface shape design support program.

Background Art

Patent Document 1 discloses a gear manufacturing method for reducing meshing vibration force.
In the gear manufacturing method described in Patent Document 1, the meshing vibration force is evaluated while changing, as modification parameters of the gear, a cut amount in the tooth profile direction and a cut length in the tooth height direction, and the modification parameter that minimizes the meshing vibration force is determined.

Citation List

Patent Literature

Patent Document 1: JP 2006-242211 A

Summary of Invention

Technical Problem

A gear for transmission is required to achieve both an improvement in load capacity and an improvement in quietness. In this regard, since the complicated tooth surface shape cannot be evaluated in the method of performing the shape evaluation while changing the simple modification parameter as described in Patent Document 1, for example, it is difficult to design the complicated tooth surface shape so as to achieve both the improvement in the load capacity of the gear and the improvement in quietness.
In view of the above circumstances, an object of the present disclosure is to provide a tooth surface shape design support device and a gear machining system capable of efficiently evaluating a complicated tooth surface shape of a gear with a small amount of calculation.

Solution to Problem

In order to achieve the object described above, a tooth surface shape design support device according to an embodiment of the present disclosure is a tooth surface shape design support device for supporting design of a tooth surface shape of a gear including, a principal component shape data acquisition unit configured to acquire a plurality of principal component shape data obtained by performing principal component analysis on a tooth surface shape sample data group including a plurality of tooth surface shape sample data indicating samples of the tooth surface shape, and a tooth surface shape evaluation unit configured to evaluate a tooth surface shape defined by using the plurality of principal component shape data acquired by the principal component shape data acquisition unit.
In order to achieve the object described above, a tooth surface shape design support program is a tooth surface shape design support program for supporting design of a tooth surface shape of a gear, the program causing a computer to execute the steps of, acquiring a plurality of principal component shape data obtained by principal component analysis on a tooth surface shape sample data group including a plurality of tooth surface shape sample data indicating samples of the tooth surface shape, and evaluating the tooth surface shape defined using the plurality of principal component shape data.

Advantageous Effects of Invention

According to the present disclosure, there are provided a tooth surface shape design support device and a gear machining system capable of efficiently evaluating a complicated tooth surface shape of a gear with a small amount of calculation.

Brief Description of Drawings

FIG. 1 is a block diagram illustrating a schematic hardware configuration of a tooth surface shape design support device 2 according to an embodiment.

FIG. 2 is a block diagram illustrating a functional schematic configuration of the tooth surface shape design support device 2 illustrated in FIG. 1.

FIG. 3 is a diagram illustrating a processing flow for evaluating a tooth surface shape of a gear.

FIG. 4 is a diagram illustrating tooth surface shape sample data D1 to D15 in a tooth surface shape sample data group Dg.

FIG. 5 is a diagram illustrating a data structure of the tooth surface shape sample data group Dg.

FIG. 6 illustrates an example of a plurality of principal component shape data $u_k$ acquired by a principal component shape data acquisition unit 6.

FIG. 7 is a diagram illustrating a data structure of each principal component shape data $u_k$.

FIG. 8 is a diagram illustrating an example of an optimum tooth surface shape determined by a tooth surface shape determination unit 10.

FIG. 9 is a block diagram illustrating a modified example of the tooth surface shape design support device 2 illustrated in FIG. 2.

FIG. 10 is a diagram illustrating a central position M1 in the tooth height direction of the tooth surface.

FIG. 11 is a diagram for describing a position $(X_i, Y_j)$.

FIG. 12 is a diagram illustrating a central position M2 in a tooth width direction of a tooth surface.

FIG. 13 is a diagram illustrating a diagonal M3 intersecting with each of the tooth width direction and the tooth height direction of the tooth surface.

FIG. 14A is a diagram illustrating positions A1, A2, and A3 in the tooth height direction.

FIG. 14B is a diagram illustrating a modified shape at the positions A1, A2, and A3 in the tooth height direction.

FIG. 15A is a diagram illustrating positions B1, B2, and B3 in the tooth width direction.

FIG. 15B is a diagram illustrating a modified shape at positions B1, B2, and B3 in the tooth width direction.

FIG. 16 is a block diagram illustrating a schematic configuration of a gear machining system 20 to which the tooth surface shape design support device 2 illustrated in FIG. 2 or FIG. 9 can be applied.

FIG. 17A is a schematic perspective view illustrating a configuration of a helical gear.

FIG. 17B is a view illustrating a machined pattern formed so as to intersect with the meshing advancing direction of the helical gear.

FIG. 18A is a schematic perspective view illustrating a configuration of a spur gear.

FIG. 18B is a view illustrating a machined pattern formed so as to intersect with the meshing advancing direction of the spur gear.

Description of Embodiments

Hereinafter, some embodiments of the present disclosure will be described with reference to the accompanying drawings. However, dimensions, materials, shapes, relative arrangements, or the like of components described in the embodiments or illustrated in the drawings are not intended to limit the scope of the present invention thereto, and are merely illustrative examples.

For instance, an expression of relative or absolute arrangement such as "in a direction", "along a direction", "parallel", "orthogonal", "centered", "concentric" or "coaxial" shall not be construed as indicating only the arrangement in a strict literal sense, but also includes a state where the arrangement is relatively displaced by a tolerance, or by an angle or a distance within a range where the same function can be achieved.

For instance, an expression of an equal state such as "same", "equal", "uniform" or the like shall not be construed as indicating only the state in which the feature is strictly equal, but also includes a state in which there is a tolerance or a difference within a range where the same function can be achieved.

Further, for example, an expression of a shape such as a rectangular shape, a cylindrical shape or the like shall not be construed as only the geometrically strict shape, but also includes a shape with unevenness, chamfered corners or the like within the range where the same effect can be achieved.

On the other hand, an expression such as "provided", "comprise", "contain", "include", or "have" are not intended to be exclusive of other components.

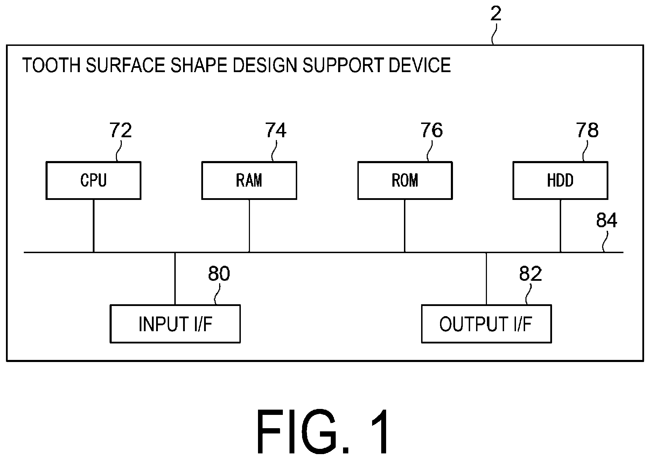

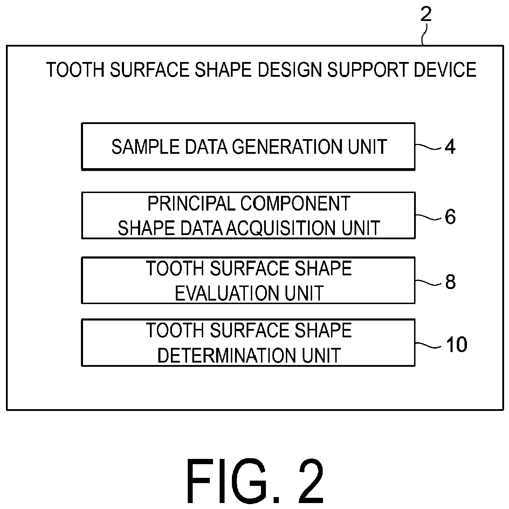

FIG. 1 is a block diagram illustrating a schematic hardware configuration of a tooth surface shape design support device 2 according to an embodiment. FIG. 2 is a block diagram illustrating a functional schematic configuration of the tooth surface shape design support device 2 illustrated in FIG. 1. The tooth surface shape design support device 2 is used to support the design of the tooth surface shape of a gear.

As illustrated in FIG. 1, the tooth surface shape design support device 2 includes a central processing unit (CPU) 72, a random access memory (RAM) 74, a read only memory (ROM) 76, a hard disk drive (HDD) 78, an input I/F 80, and an output I/F 82, and is configured using a computer in which these components are connected to each other via a bus 84. The hardware configuration of the tooth surface shape design support device 2 is not limited to the above, and may be configured by a combination of a control circuit and a storage device. The tooth surface shape design support device 2 is configured by a computer executing a program (tooth surface shape design support program) that realizes each function of the tooth surface shape design support device 2. The function of each unit in the tooth surface shape design support device 2 described below is realized by, for example, loading a program held in a ROM 76 into the RAM 74 and executing the program by the CPU 72, and reading and writing data in the RAM 74 and the ROM 76.

As illustrated in FIG. 2, the tooth surface shape design support device 2 includes a sample data generation unit 4, the principal component shape data acquisition unit 6, a tooth surface shape evaluation unit 8, and the tooth surface shape determination unit 10. The functions of each component illustrated in FIG. 2 will be described below.

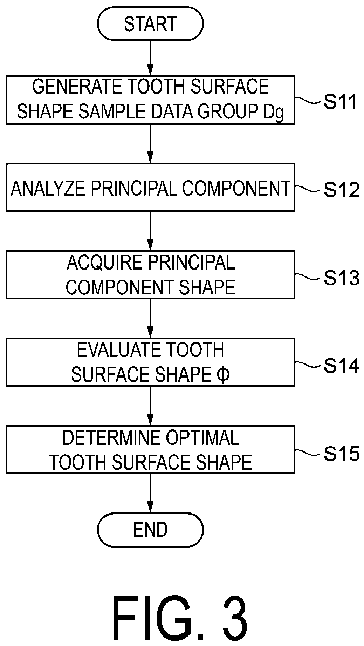

FIG. 3 is a diagram illustrating a processing flow for evaluating a tooth surface shape of a gear.

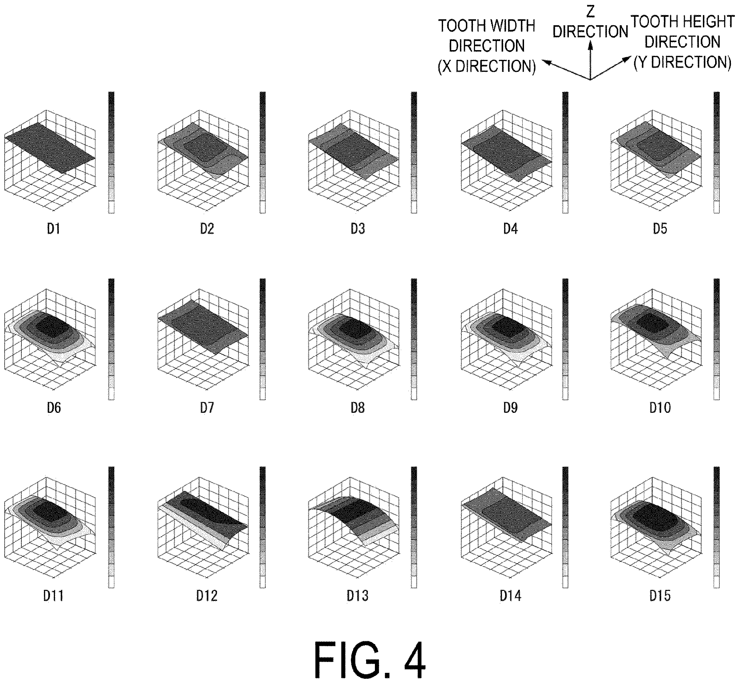

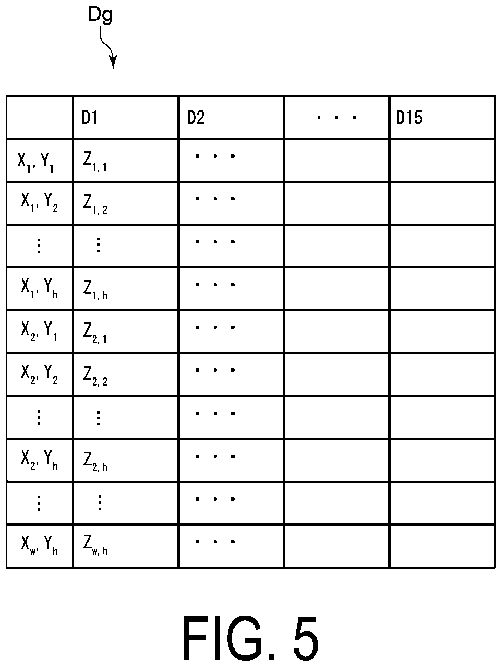

In S11 of FIG. 3, the sample data generation unit 4 generates the tooth surface shape sample data group Dg as illustrated in FIG. 4 using at least one tooth surface modification parameter based on general tooth surface design guidelines (low stress design and low vibration force design). The tooth surface shape sample data group Dg illustrated in FIG. 4 includes tooth surface shape sample data D1 to D15 indicating samples of tooth surface shape, and each of the tooth surface shape sample data D1 to D15 indicates a three-dimensional shape of a tooth surface. When the position in the tooth width direction (X direction) is defined as $X_i$, the position in the tooth height direction (Y direction) is defined as $Y_j$, and the position in the direction orthogonal to each of the tooth width direction and the tooth height direction (Z Direction) is defined as $Z_{i,j}$, the tooth surface shape sample data group Dg is, for example, as illustrated in FIG. 5, point sequence data (matrix data) showing the Z coordinate $Z_{i,j}$ of the tooth surface in each position coordinate $(X_i, Y_j)$ for each of the tooth surface shape sample data D1 to D15. Here, when the number of data in the tooth width direction in each of the tooth surface shape sample data D1 to D15 is defined as w and the number of data in the tooth height direction is defined as h, i is an integer from 1 to w and j is an integer from 1 to h.

The at least one tooth surface modification parameter includes, for example, at least one of a tooth profile modification, a tooth trace modification, a bias modification, a pressure angle modification, and a helix angle modification. The tooth profile modification includes, for example, at least one of a tooth tip modification and a tooth root modification, and the tooth trace modification includes, for example, at least one of crowning and end relief. In addition, the low stress design includes a design in which the tooth tip, the tooth root, and the end portion of the tooth trace are modified so as not to come into contact with each other, and the amount of modification substantially matches the amount of warping of the tooth. In addition, the low vibration force design includes a design in which the modification is performed such that rigidity variation caused by the change in the number of engaged teeth is canceled.

Next, in the S12 of FIG. 3, the principal component shape data acquisition unit 6 performs principal component analysis (eigenvalue orthogonal analysis) on the tooth surface shape sample data group Dg. Then, in the S13, the principal component shape data acquisition unit 6 extracts and acquires a plurality of principal component shape data $u_k$ from the result of the principal component analysis on the tooth surface shape sample data group Dg.

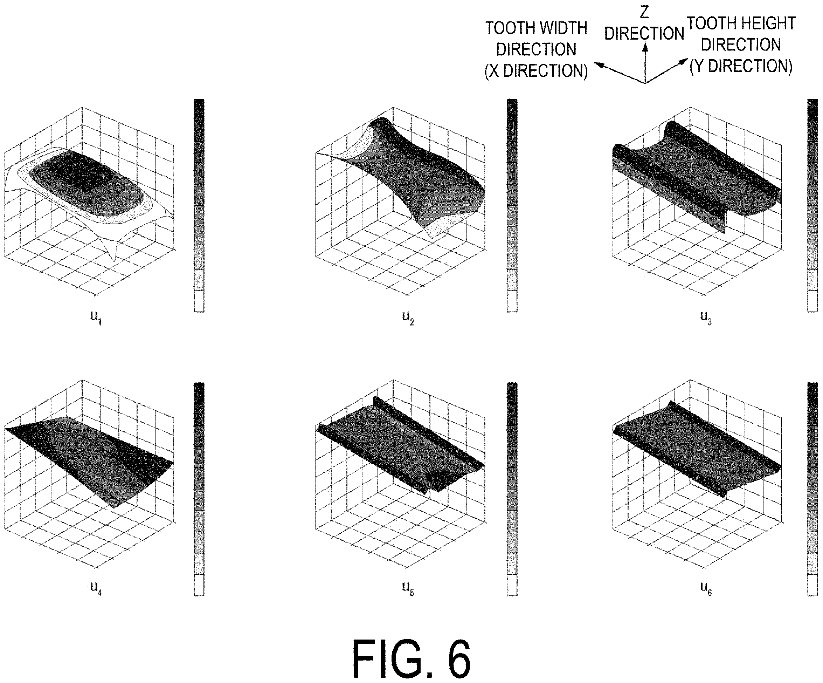

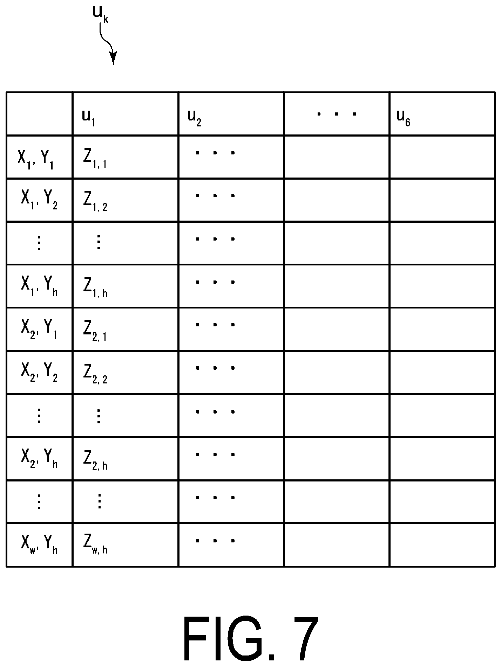

FIG. 6 illustrates an example of a plurality of principal component shape data $u_k$ acquired by the principal component shape data acquisition unit 6. Here, k is the order of the principal component shape, and in the example illustrated in FIG. 6, k is an integer from 1 to 6. In the illustrated example, first-order principal component shape data $u_1$, second-order principal component shape data $u_2$, third-order principal component shape data $u_3$, fourth-order principal component shape data $u_4$, fifth-order principal component shape data $u_5$, and sixth-order principal component shape data $u_6$ are illustrated, which are extracted from the result of the principal component analysis on the tooth surface shape sample data group Dg. As illustrated in FIG. 7, each of the principal component shape data $u_1$ to $u_6$ is point sequence data (matrix data) indicating the position $Z_{i,j}$ of the tooth surface at each position coordinate $(X_i, Y_j)$. Here, when the number of data in the tooth width direction in each of the principal component shape data $u_1$ to $u_6$ is defined as w and the number of data in the tooth height direction is defined as h, i is an integer from 1 to w and j is an integer from 1 to h.

Next, in the S14, the tooth surface shape evaluation unit 8 evaluates the tooth surface shape $\Phi$ defined using a linear combination of the plurality of principal component shape data $u_k$ acquired by the principal component shape data acquisition unit 6. Here, the tooth surface shape evaluation unit 8 defines the tooth surface shape $\Phi$ by the following Equation (a).

$$\Phi = v + \sum_{k=1}^{n} \alpha_k \, u_k \qquad (a)$$

Here, v is average shape of the tooth surface shape indicated by each of the tooth surface shape sample data D1 to D15, $\alpha_k$ is a linear combination coefficient of the principal component shape data $u_k$, and n is the maximum order (6 in the above example) of the principal component shape data extracted from the result of the principal component analysis.

In the S14, the tooth surface shape evaluation unit 8 performs gear analysis on the gear having the tooth surface shape $\Phi$, and evaluates the tooth surface shape $\Phi$ by evaluating stress (e.g., surface pressure and tooth root stress) and vibration force generated in the gear. Here, the tooth surface shape evaluation unit 8 evaluates a plurality of tooth surface shapes Φ obtained by changing the linear combination coefficient $\alpha_k$.

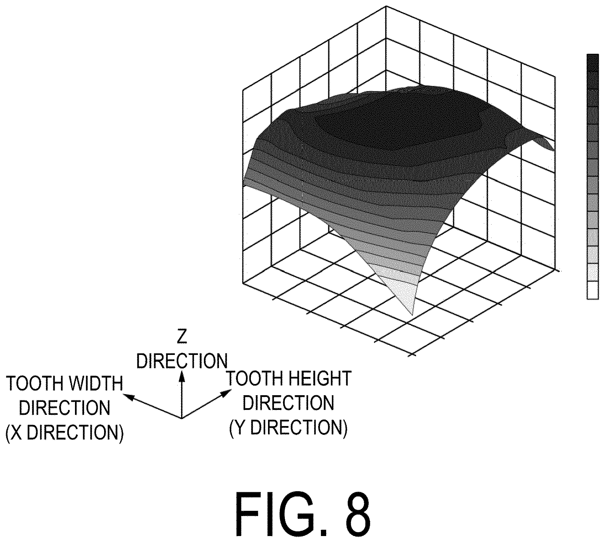

In the S15, the tooth surface shape determination unit 10 determines an optimum tooth surface shape (e.g., see FIG. 8) that can achieve both low stress and low vibration force based on the result (result of parameter study with linear combination coefficient $\alpha_k$ as parameter) of evaluation by the tooth surface shape evaluation unit 8 on the plurality of tooth surface shapes Φ obtained by changing the linear combination coefficient $\alpha_k$. Thus, an optimum tooth surface shape capable of achieving both improvement in load capacity and improvement in quietness is determined. When the number of analyses is enormous, the tooth surface shape evaluation unit 8 and the tooth surface shape determination unit 10 may appropriately use an optimization method such as a Monte Carlo method.

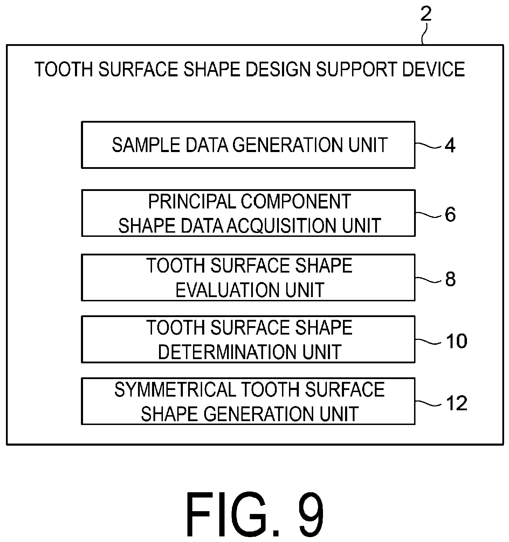

FIG. 9 is a block diagram illustrating a modified example of the tooth surface shape design support device 2 described with reference to FIG. 2 or the like. The tooth surface shape design support device 2 illustrated in FIG. 9 is different from the tooth surface shape design support device 2 illustrated in FIG. 2 in that the tooth surface shape design support device 2 illustrated in FIG. 9 includes a symmetrical tooth surface shape generation unit 12. For each configuration of the tooth surface shape design support device 2 illustrated in FIG. 9, the same reference sign as that of each configuration of the tooth surface shape design support device 2 illustrated in FIG. 2 or the like indicate the same configuration as that of each configuration of the tooth surface shape design support device 2 illustrated in FIG. 2 or the like unless otherwise specified, and description thereof will be omitted.

The symmetrical tooth surface shape generation unit 12 generates a plurality of tooth surface shape data $\Delta_k$ having symmetrical shapes based on each of the plurality of principal component shape data $u_k$ acquired by the principal component shape data acquisition unit 6. Hereinafter, the principal component shape indicated by the principal component shape data $u_k$ is also referred to as a principal component shape $u_k$ for convenience.

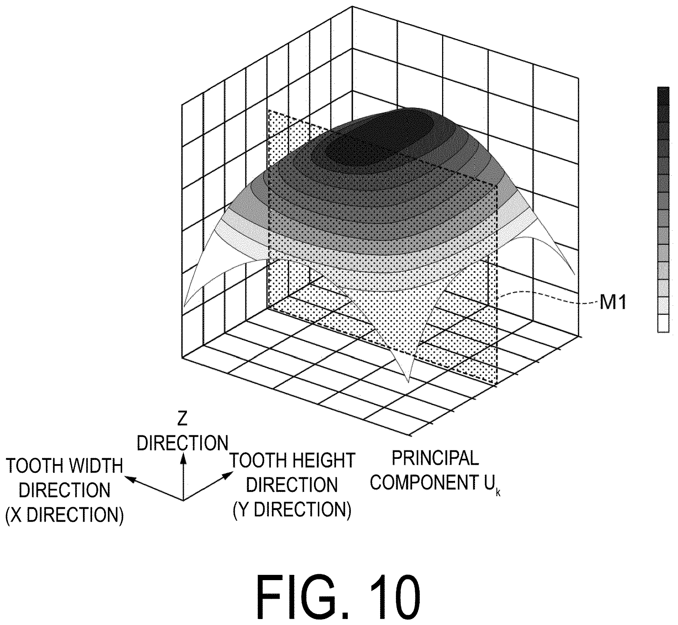

For each of the principal component shape data $u_k$ acquired by the principal component shape data acquisition unit 6, as expressed in the following Equation (b1), the symmetrical tooth surface shape generation unit 12 generates tooth surface shape data $\Delta_{1\_i,j}$ having a symmetrical shape by averaging Z coordinates at symmetrical positions in the tooth surface with the central position M1 (see FIG. 10) of the tooth surface in the tooth height direction as an axis of symmetry.

$$\Delta_{1\_i,j} = (Z_{i,j} + Z_{i,(h-j+1)})/2 \ (b1)$$

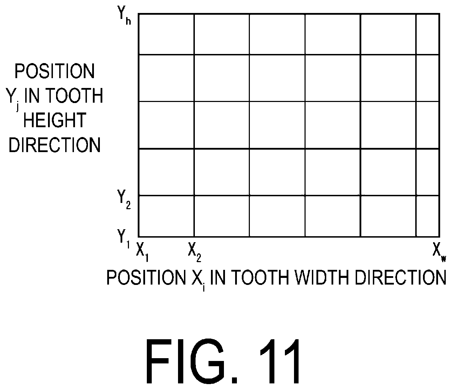

Here, as illustrated in FIG. 11, when the number of data in the tooth width direction in each of the principal component shape data $u_k$ is defined as w and the number of data in the tooth height direction is defined as h, i is an integer from 1 to w and j is an integer from 1 to h. Further, $Z_{i,j}$ is the Z coordinate of the principal component shape $u_k$ at a position $(X_i, Y_j)$, and $Z_{i,(h-j+1)}$ is the Z coordinate of the principal component shape $u_k$ at a position $(X_i, Y_{(h-j+1)})$ symmetrical to the position $(X_i, Y_j)$ with the central position M1 as an axis of symmetry.

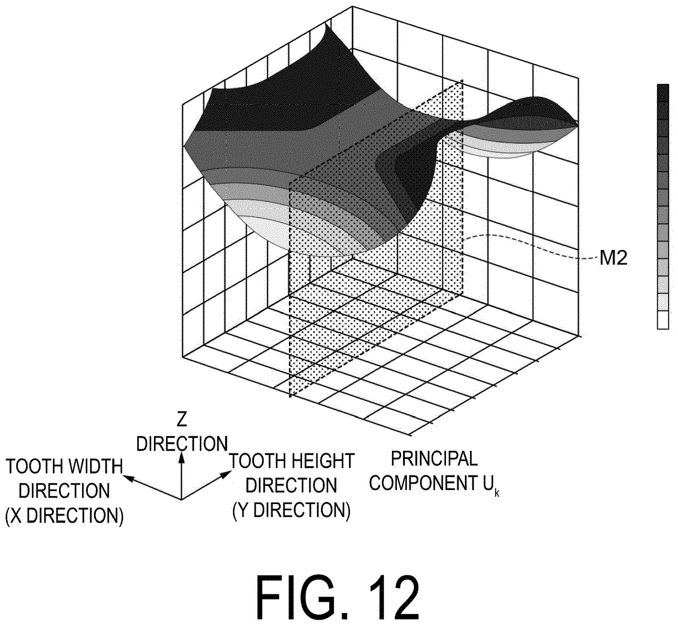

For each of the principal component shape data $u_k$ acquired by the principal component shape data acquisition unit 6, as expressed in the following Equation (b2), the symmetrical tooth surface shape generation unit 12 generates tooth surface shape data $\Delta_{2\_i,j}$ having a symmetrical shape by averaging Z coordinates at symmetrical positions in the tooth surface with the central position M2 (see FIG. 12) of the tooth surface in the tooth width direction as an axis of symmetry.

$$\Delta_{2\_i,j} = (Z_{i,j} + Z_{(w-i+1),j})/2 \ (b2)$$

Here, $Z_{(w-i+1),j}$ is the Z coordinate of the principal component shape $u_k$ at the symmetrical position $(X_{(w-i+1)}, Y_j)$ of the position $(X_i, Y_j)$ with the central position M2 as the axis of symmetry.

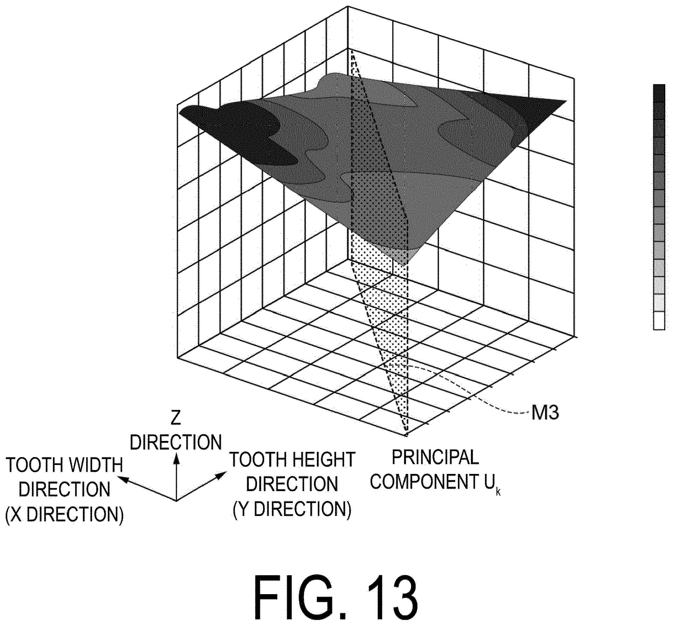

For each of the principal component shape data $u_k$ acquired by the principal component shape data acquisition unit 6, as expressed in the following Equation (b3), the symmetrical tooth surface shape generation unit 12 generates tooth surface shape data $\Delta_{3\_i,j}$ having a symmetrical shape by averaging Z coordinates at symmetrical positions in the tooth surface with a diagonal M3 (see FIG. 13) intersecting each of the tooth width direction and the tooth height direction of the tooth surface as an axis of symmetry.

$$\Delta_{3\_i,j} = (Z_{i,j} + Z_{j,i})/2 \ (b3)$$

Here, $Z_{j,i}$ is the Z coordinate of the principal component shape $u_k$ at the symmetrical position $(X_j, Y_i)$ of the position $(X_i, Y_j)$ with the diagonal M3 as an axis of symmetry.

Additionally, for each of the principal component shape data $u_k$ acquired by the principal component shape data acquisition unit 6, as expressed in the following Equation (b4), the symmetrical tooth surface shape generation unit 12 generates tooth surface shape data $\Delta_{4\_i,j}$ having a symmetrical shape by averaging Z coordinates at symmetrical positions in the tooth surface with a diagonal M4 (not illustrated) intersecting each of the tooth width direction and the tooth height direction of the tooth surface as an axis of symmetry.

$$\Delta_{4\_i,j} = (Z_{i,j} + Z_{(w-i+1),(h-j+1)})/2 \quad (b4)$$

Here, $Z_{(w-i+1),(h-j+1)}$ is the Z coordinate of the principal component shape $u_k$ at the symmetrical position $(Y_{(w-i+1)}, X_{(h-j+1)})$ of the position $(X_i, Y_j)$ with the diagonal M4 as an axis of symmetry.

From among the central positions M1 and M2, and diagonals M3 and M4, the symmetrical tooth surface shape generation unit 12 selects the axis of symmetry having the smallest sum of differences between the principal component shape $u_k$ and each of the symmetrical shapes $\Delta_{1\_i,j}$ to $\Delta_{4\_i,j}$ as expressed in the following Equation (c). Then, data $\Delta_{i,j}$ of a tooth surface shape having a symmetrical shape using the selected axis of symmetry are determined.

$$\Delta_{i,j} = \min \{\Sigma \,|Z_{i,j} - \Delta_{1\_i,j}|, \, \Sigma \,|Z_{i,j} - \Delta_{2\_i,j}|, \, \Sigma \,|Z_{i,j} - \Delta_{3\_i,j}|, \, \Sigma \,|Z_{i,j} - \Delta_{4\_i,j}|\} \quad (c)$$

Then, the tooth surface shape evaluation unit 8 evaluates the tooth surface shape $\Phi$ defined by the following Equation (d) using the linear combination of the tooth surface shape data $\Delta_{i,j}$ having the symmetrical shape determined by the symmetrical tooth surface shape generation unit 12.

$$\Phi = v + \sum_{k=1}^{n} \beta_k \Delta_k \quad (d)$$

Here, v is the average shape of the tooth surface shapes indicated by each of the tooth surface shape sample data D1 to D15, $\Delta_k$ is the tooth surface shape data $\Delta_{i,j}$ having the symmetrical shape determined using the principal component shape $u_k$, $\beta_k$ is the linear combination coefficient of the tooth surface shape data $\Delta_k$ having the symmetrical shape, and n is the maximum order (6 in the above example) of the principal component shape data extracted from the result of the principal component analysis.

The tooth surface shape evaluation unit 8 performs gear analysis on the gear having the tooth surface shape $\Phi$, and evaluates the tooth surface shape $\Phi$ by stress (e.g., surface pressure and tooth root stress) and vibration force generated in the gear. Here, the tooth surface shape evaluation unit 8 evaluates a plurality of tooth surface shapes $\Phi$ obtained by changing the linear combination coefficient of the tooth surface shape data $\Delta_{i,j}$.

The tooth surface shape determination unit 10 determines an optimum tooth surface shape capable of achieving both low stress and low vibration force based on the evaluation result by the tooth surface shape evaluation unit 8 with respect to a plurality of tooth surface shapes $\Phi$ obtained by changing the linear combination coefficient of the tooth surface shape data $\Delta_{i,j}$.

In the embodiment illustrated in FIGS. 9 to 13, since the gear analysis is performed using the principal component shape in which the discontinuity of the point sequence data is reduced by performing the averaging process for generating the symmetrical shape, the discontinuity of the point sequence data is reduced in the generated optimum tooth surface shape, and the generated optimum tooth surface shape becomes a smooth curved surface as compared with the embodiment illustrated in FIG. 2 or the like. Therefore, processing management and accuracy management are facilitated.

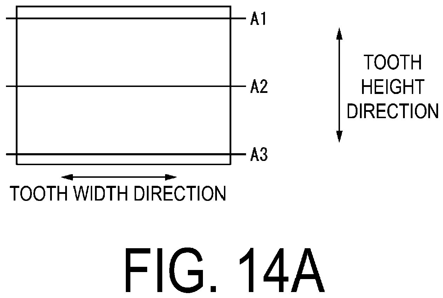

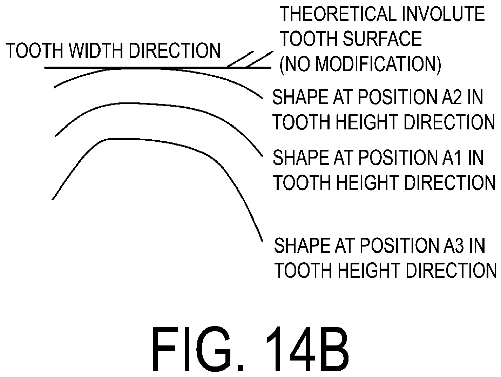

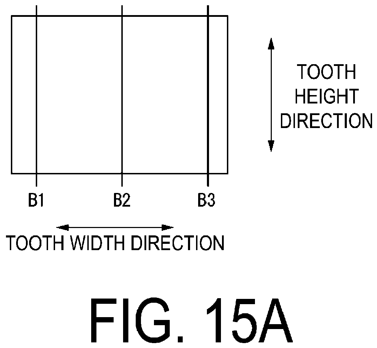

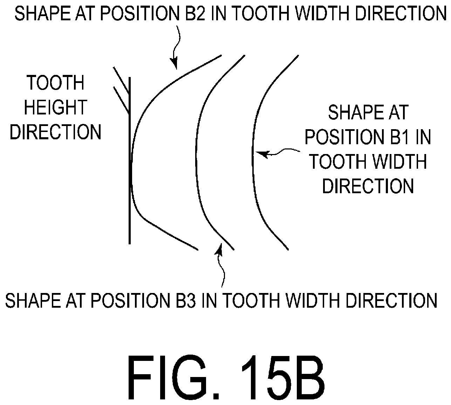

Further, since the gear analysis is performed using the principal component shape obtained by symmetrically shaping and simplifying the shape, even when the generated optimum tooth surface shape is represented in a drawing by a modified shape represented by several lines in the tooth width direction (e.g., modified shapes at the positions A1, A2, and A3 in the tooth height direction as illustrated in FIGS. 14A and 14B) or by a modified shape represented by several lines in the tooth height direction (e.g., modified shapes at the positions B1, B2, and B3 in the tooth width direction as illustrated in FIGS. 15A and 15B), the difference from the optimum tooth surface shape becomes small because the section between the indicated shape data is subjected to spline interpolation or the like during machining. Therefore, it becomes easy to describe in the drawings, instruct the manufacturing department or supplier, and manage the machining accuracy.

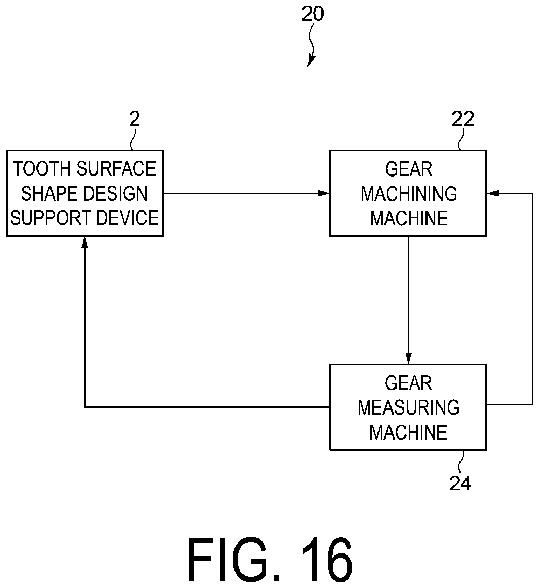

FIG. 16 is a block diagram illustrating a schematic configuration of the gear machining system 20 to which the tooth surface shape design support device 2 illustrated in FIG. 2 or FIG. 9 can be applied. A gear machining system 20 illustrated in FIG. 16 includes a tooth surface shape design support device 2, a gear machining machine 22, and a gear measuring machine 24.

The gear machining machine 22 is configured to machine the tooth surface of the gear based on the optimum tooth surface shape determined by the tooth surface shape design support device 2.

The gear measuring machine 24 measures the actual tooth surface shape of the gear (workpiece) machined by the gear machining machine 22, and transmits measurement data of the tooth surface shape to the tooth surface shape design support device 2. The tooth surface shape design support device 2 analyzes the surface pressure, the tooth root stress, and the vibration force reflecting the measured actual tooth surface shape, and uses them for designing the tooth surface shape. Further, the gear machining machine 22 can reduce the machining error by performing the tooth surface correction and the dimension correction of the gear based on the measurement data of the tooth surface shape measured by the gear measuring machine 24.

In some embodiments, the gear machining machine 22 illustrated in FIG. 16 may be a five-axis machining machine. Thus, even when the tooth surface shape determined by the tooth surface shape design support device 2 is a complicated shape, the tooth surface shape can be accurately realized.

Further, in this case, the gear machining machine 22 is preferably configured to machine the tooth surface such that the machined pattern intersects with the meshing advancing direction of the gear, and more preferably configured to machine the tooth surface such that the machined pattern is orthogonal to the meshing advancing direction of the gear. That is, the tool path (the path along which the tool moves when machining is performed) of the gear machining machine 22 is preferably set so as to intersect with the meshing advancing direction of the gear, and more preferably set so as to be orthogonal to the meshing advancing direction of the gear.

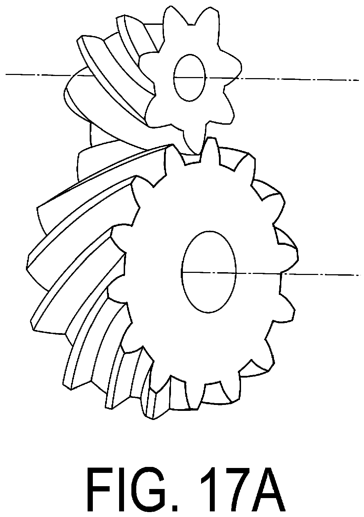

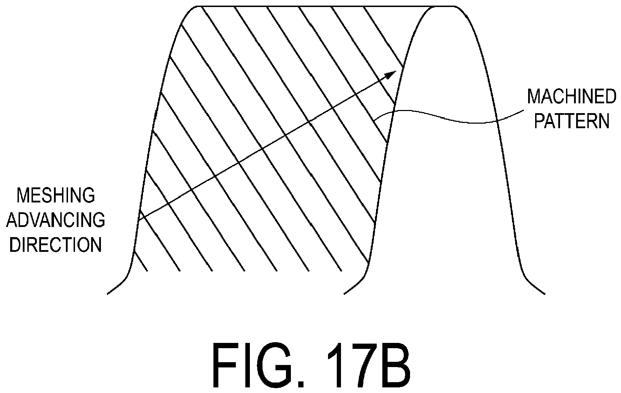

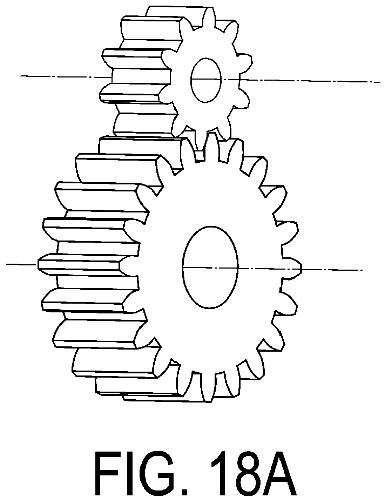

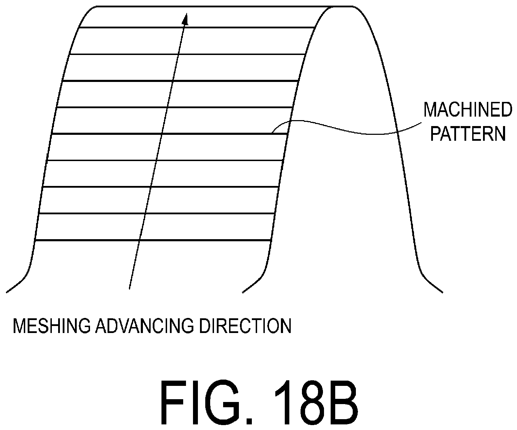

Therefore, for example, for a spur gear as illustrated in FIG. 18A, it is desirable that the gear machining machine 22 machines the tooth surface so that a machined pattern is formed along the axial direction as illustrated in FIG. 18B. In addition, for example, for a helical gear as illustrated in FIG. 17A, it is preferable that the gear machining machine 22 machines the tooth surface so that a machined pattern is formed along an oblique direction intersecting each of the axial direction and the radial direction as illustrated in FIG. 17B. In the case of a helical gear, the angle of the meshing advancing direction changes depending on the helix angle of the helical gear.

In this way, by causing the machined pattern to intersect with the meshing advancing direction of the gear, it is possible to expect an increase in the thickness of the oil film on the tooth surface as compared with the case where the machined pattern is formed in parallel with the meshing advancing direction of the gear, and it is possible to expect an improvement in load capacity (durability) due to an increase in support load (decrease in solid contact load) through the oil film. Therefore, it is possible to achieve both an improvement in load capacity and an improvement in quietness.

The present disclosure is not limited to the above-described embodiments, and includes embodiments obtained by modifying the above-described embodiments and embodiments obtained by appropriately combining these embodiments.

For example, in the embodiment illustrated in FIG. 9 or the like, the symmetrical tooth surface shape generation unit 12 has selected, from among the central positions M1 and M2, and diagonals M3 and M4, the axis of symmetry having the smallest sum of differences between the principal component shape $u_k$ and each of the symmetrical shapes $\Delta_{1\_i,j}$ to $\Delta_{4\_i,j}$, and then, tooth surface shape data $\Delta_{i,j}$ having a symmetrical shape using the selected axis of symmetry have been determined. However, the symmetrical tooth surface shape generation unit 12 can generate a plurality of tooth surface shape data $\Delta_{i,j}$ having a symmetrical shape by averaging the Z coordinates at symmetrical positions in the tooth surface, with at least one of the central positions M1 and M2, and the diagonals M3 and M4 as an axis of symmetry for each of the principal component shape data $u_k$. For example, the symmetrical tooth surface shape generation unit 12 may generate only one of the symmetrical shapes $\Delta_{1\_i,j}$ to $\Delta_{4\_i,j}$ as the tooth surface shape data $\Delta_{i,j}$ having the symmetrical shape, and the tooth surface shape evaluation unit 8 may evaluate the data $\Delta_{i,j}$.

In some embodiments described above, the principal component analysis on the tooth surface shape sample data group Dg is performed by the principal component shape data acquisition unit 6, but the principal component analysis on the tooth surface shape sample data group Dg may be performed outside the tooth surface shape design support device 2. That is, principal component analysis may be performed on the tooth surface shape sample data group Dg outside the tooth surface shape design support device 2, and the principal component shape data acquisition unit 6 may acquire the principal component shape data $u_k$ extracted from the result of the principal component analysis.

The content described in each of the above embodiments is understood as follows, for example.

(1) A tooth surface shape design support device (e.g., the above-described tooth surface shape design support device 2) according to at least one embodiment of the present disclosure is a tooth surface shape design support device for supporting design of a tooth surface shape of a gear, including a principal component shape data acquisition unit (e.g., the above-described principal component shape data acquisition unit 6) configured to acquire a plurality of principal component shape data obtained by performing principal component analysis on a tooth surface shape sample data group including a plurality of tooth surface shape sample data indicating samples of the tooth surface shape, and a tooth surface shape evaluation unit (e.g., the above-described tooth surface shape evaluation unit 8) configured to evaluate a tooth surface shape defined by using the plurality of principal component shape data acquired by the principal component shape data acquisition unit.

According to the tooth surface shape design support device described in the above (1), as compared with the case where the tooth surface shape is evaluated by using all the coordinates of the tooth surface shape as parameters, by evaluating the tooth surface shape defined by using a plurality of principal component shape data obtained by principal component analysis for a tooth surface shape sample data group, it is possible to efficiently evaluate a complicated tooth surface shape with a small amount of calculation. Thus, for example, it is possible to effectively support the design of a complicated tooth surface shape so as to achieve both improvement in load capacity and improvement in quietness of the gear with a small amount of calculation.

(2) In some embodiments, in the tooth surface shape design support device according to the above (1), the tooth surface shape evaluation unit is configured to evaluate stress and vibration force generated in the gear.

According to the tooth surface shape design support device described in the above (2), it is possible to efficiently evaluate stress and vibration force generated in a gear having a complicated tooth surface shape with a small amount of calculation. Thus, it is possible to effectively support the design of a complicated tooth surface shape so as to achieve both improvement in load capacity and improvement in quietness of the gear with a small amount of calculation.

(3) In some embodiments, the tooth surface shape design support device according to the above (1) or (2) further includes, a sample data generation unit (e.g., the above-described sample data generation unit 4) configured to generate the tooth surface shape sample data group by using at least one tooth surface modification parameter among tooth profile modification, tooth trace modification, bias modification, pressure angle modification, and helix angle modification.

According to the tooth surface shape design support device described in the above (3), since the principal component shape data acquired from the tooth surface shape sample data group generated using at least one tooth surface modification parameter can be evaluated, a complicated tooth surface shape can be efficiently evaluated with a small amount of calculation. Thus, for example, it is possible to effectively support the design of a complicated tooth surface shape so as to achieve both improvement in load capacity and improvement in quietness of the gear with a small amount of calculation.

(4) In some embodiments, in the tooth surface shape design support device according to any one of the above (1) to (3), the tooth surface shape evaluation unit is configured to define the tooth surface shape by using a linear combination of the plurality of principal component shape data acquired by the principal component shape data acquisition unit, and to evaluate a plurality of tooth surface shapes obtained by changing a coefficient of the linear combination.

According to the tooth surface shape design support device described in the above (4), a complicated tooth surface shape can be efficiently defined and efficiently evaluated with a small amount of calculation.

(5) In some embodiments, the tooth surface shape design support device according to any one of the above (1) to (3) further includes, a symmetrical tooth surface shape generation unit (e.g., the symmetrical tooth surface shape generation unit 12 described above) configured to generate a plurality of tooth surface shape data having symmetrical shapes based on each of the plurality of principal component shape data acquired by the principal component shape data acquisition unit, and the tooth surface shape evaluation unit is configured to define the tooth surface shape by using a linear combination of the plurality of tooth surface shape data having the symmetrical shapes generated by the symmetrical tooth surface shape generation unit, and to evaluate a plurality of tooth surface shapes obtained by changing coefficients of the linear combination.

According to the tooth surface shape design support device described in the above (5), a complicated tooth surface shape can be efficiently defined and evaluated with a small amount of calculation.

(6) In some embodiments, in the tooth surface shape design support device according to the above (5), when a position in a direction orthogonal to each of the tooth width direction and the tooth height direction is defined as a Z coordinate, the symmetrical tooth surface shape generation unit is configured to generate a plurality of tooth surface shape data having the symmetrical shape by averaging Z coordinates at symmetrical positions in the tooth surface, with at least one of a central position of the tooth surface in the tooth width direction, a central position of the tooth surface in the tooth height direction, and a diagonal of the tooth surface as an axis of symmetry, for each of the plurality of principal component shape data acquired by the principal component shape data acquisition unit.

According to the tooth surface shape design support device described in the above (6), since the tooth surface shape defined by using the principal component shape data is evaluated with respect to the principal component shape data in which the discontinuity of the point sequence data is reduced by performing the averaging process, it is possible to evaluate the tooth surface shape of the smooth curved surface. Therefore, it is possible to design a tooth surface shape having a smooth curved surface with small discontinuity of the point sequence data, and it is easy to perform processing management and accuracy management.

(7) In some embodiments, the tooth surface shape design support device according to any one of the above (1) to (6) further includes a tooth surface shape determination unit (e.g., the tooth surface shape determination unit 10 described above) configured to determine the tooth surface shape of the gear based on an evaluation result of the tooth surface shape evaluation unit.

According to the tooth surface shape design support device described in the above (7), it is possible to efficiently determine a complicated tooth surface shape with a small amount of calculation. Thus, for example, it is possible to effectively support the design of a complicated tooth surface shape so as to achieve both improvement in load capacity and improvement in quietness of the gear with a small amount of calculation.

(8) A gear machining system (e.g., the above-described gear machining system 20) according to at least one embodiment of the present disclosure includes, the tooth surface shape design support device according to the above (7), and a gear machining machine (e.g., the above-described gear machining machine 22) that machines a tooth surface of a gear based on the tooth surface shape determined by the tooth surface shape design support device.

According to the gear machining system described in the above (8), it is possible to manufacture a gear excellent in load capacity and quietness.

(9) In some embodiments, in the gear machining system according to the above (8), the gear machining machine is configured to machine the tooth surface such that a machined pattern intersects with a meshing advancing direction of the gear.

According to the gear machining system described in the above (9), by causing the machined pattern to intersect with the meshing advancing direction of the gear, it is possible to expect an increase in the thickness of the oil film on the tooth surface as compared with the case where the machined pattern is formed in parallel with the meshing advancing direction of the gear. Therefore, it is expected that the load capacity (durability) will be improved due to an increase of the support load through the oil film (a decrease of the solid contact load). Therefore, it is possible to achieve both an improvement in load capacity and an improvement in quietness.

(10) A tooth surface shape design support program according to at least one embodiment of the present disclosure is a tooth surface shape design support program for supporting design of a tooth surface shape of a gear, the program causing a computer to execute the steps of, acquiring a plurality of principal component shape data obtained by performing principal component analysis on a tooth surface shape sample data group including a plurality of tooth surface shape sample data indicating samples of the tooth surface shape, and evaluating the tooth surface shape defined by using the plurality of principal component shape data.

According to the tooth surface shape design support program described in the above (10), as compared with the case where the tooth surface shape is evaluated by using all the coordinates of the tooth surface shape as parameters, the tooth surface shape defined by using the plurality of principal component shape data obtained by the principal component analysis with respect to the tooth surface shape sample data group is evaluated and thus it is possible to efficiently evaluate the complicated tooth surface shape with a small amount of calculation. Thus, for example, it is possible to effectively support the design of a complicated tooth surface shape so as to achieve both improvement in load capacity and improvement in quietness of the gear with a small amount of calculation.

Reference Signs List

2 Tooth surface shape design support device
4 Sample data generation unit
6 Principal component shape data acquisition unit
8 Tooth surface shape evaluation unit
10 Tooth surface shape determination unit
12 Symmetrical tooth surface shape generation unit
20 Gear machining system
22 Gear machining machine
24 Gear measuring machine
72 CPU
74 RAM
76 ROM
78 HDD
80 Input I/F
82 Output I/F
84 Bus

**Claims**

1.  A tooth surface shape design support device for supporting design of a tooth surface shape of a gear, comprising:

    a principal component shape data acquisition unit configured to acquire a plurality of principal component shape data obtained by performing principal component analysis on a tooth surface shape sample data group including a plurality of tooth surface shape sample data indicating samples of the tooth surface shape; and
    a tooth surface shape evaluation unit configured to evaluate a tooth surface shape defined by using the plurality of principal component shape data acquired by the principal component shape data acquisition unit.

2.  The tooth surface shape design support device according to claim 1, wherein the tooth surface shape evaluation unit is configured to evaluate stress and vibration force generated in the gear.

3.  The tooth surface shape design support device according to claim 1 or 2, further comprising:
    a sample data generation unit configured to generate the tooth surface shape sample data group by using at least one tooth surface modification parameter among tooth profile modification, tooth trace modification, bias modification, pressure angle modification, and helix angle modification.

4.  The tooth surface shape design support device according to any one of claims 1 to 3, wherein the tooth surface shape evaluation unit is configured to define the tooth surface shape by using a linear combination of the plurality of principal component shape data acquired by the principal component shape data acquisition unit, and to evaluate a plurality of tooth surface shapes obtained by changing a coefficient of the linear combination.

5.  The tooth surface shape design support device according to any one of claims 1 to 3, further comprising:

    a symmetrical tooth surface shape generation unit configured to generate a plurality of tooth surface shape data having symmetrical shapes based on each of the plurality of principal component shape data acquired by the principal component shape data acquisition unit, wherein
    the tooth surface shape evaluation unit is configured to define the tooth surface shape by using a linear combination of the plurality of tooth surface shape data having the symmetrical shapes generated by the symmetrical tooth surface shape generation unit, and to evaluate a plurality of tooth surface shapes obtained by changing a coefficient of the linear combination.

6.  The tooth surface shape design support device according to claim 5, wherein
    when a position in a direction orthogonal to each of a tooth width direction and a tooth height direction is defined as a Z coordinate,
    the symmetrical tooth surface shape generation unit generates a plurality of tooth surface shape data having the symmetrical shape by averaging Z coordinates at symmetrical positions in the tooth surface, with at least one of a central position of the tooth surface in the tooth width direction, a central position of the tooth surface in the tooth height direction, and a diagonal of the tooth surface as an axis of symmetry, for each of the plurality of principal component shape data acquired by the principal component shape data acquisition unit.

7.  The tooth surface shape design support device according to any one of claims 1 to 6, further comprising:
    a tooth surface shape determination unit configured to determine the tooth surface shape of the gear based on an evaluation result of the tooth surface shape evaluation unit.

8.  A gear machining system, comprising:

    the tooth surface shape design support device according to claim 7; and
    a gear machining machine that machines a tooth surface of a gear based on the tooth surface shape determined by the tooth surface shape design support device.

9.  The gear machining system according to claim 8, wherein the gear machining machine is configured to machine the tooth surface such that a machined pattern intersects with a meshing advancing direction of the gear.

10. A tooth surface shape design support program for supporting design of a tooth surface shape of a gear, the program causing a computer to execute the steps of:

acquiring a plurality of principal component shape data obtained by performing principal component analysis on a tooth surface shape sample data group including a plurality of tooth surface shape sample data indicating samples of the tooth surface shape; and
evaluating the tooth surface shape defined by using the plurality of principal component shape data.

## TOOTH SURFACE SHAPE DESIGN SUPPORT DEVICE

2

72 CPU

74 RAM

76 ROM

78 HDD

84

80 INPUT I/F

82 OUTPUT I/F

# FIG. 1

FIG. 2

START

GENERATE TOOTH SURFACE
SHAPE SAMPLE DATA GROUP Dg — S11

ANALYZE PRINCIPAL COMPONENT — S12

ACQUIRE PRINCIPAL
COMPONENT SHAPE — S13

EVALUATE TOOTH
SURFACE SHAPE Φ — S14

DETERMINE OPTIMAL
TOOTH SURFACE SHAPE — S15

END

# FIG. 3

FIG. 4

Dg

| | D1 | D2 | $\cdots$ | D15 |
|---|---|---|---|---|
| $X_1, Y_1$ | $Z_{1,1}$ | $\cdots$ | | |
| $X_1, Y_2$ | $Z_{1,2}$ | $\cdots$ | | |
| $\vdots$ | $\vdots$ | $\cdots$ | | |
| $X_1, Y_h$ | $Z_{1,h}$ | $\cdots$ | | |
| $X_2, Y_1$ | $Z_{2,1}$ | $\cdots$ | | |
| $X_2, Y_2$ | $Z_{2,2}$ | $\cdots$ | | |
| $\vdots$ | $\vdots$ | $\cdots$ | | |
| $X_2, Y_h$ | $Z_{2,h}$ | $\cdots$ | | |
| $\vdots$ | $\vdots$ | $\cdots$ | | |
| $X_w, Y_h$ | $Z_{w,h}$ | $\cdots$ | | |

# FIG. 5

TOOTH WIDTH
DIRECTION
(X DIRECTION)

Z
DIRECTION

TOOTH HEIGHT
DIRECTION
(Y DIRECTION)

$u_1$

$u_2$

$u_3$

$u_4$

$u_5$

$u_6$

# FIG. 6

$u_k$

| | $u_1$ | $u_2$ | $\cdots$ | $u_6$ |
|---|---|---|---|---|
| $X_1, Y_1$ | $Z_{1,1}$ | $\cdots$ | | |
| $X_1, Y_2$ | $Z_{1,2}$ | $\cdots$ | | |
| $\vdots$ | $\vdots$ | $\cdots$ | | |
| $X_1, Y_h$ | $Z_{1,h}$ | $\cdots$ | | |
| $X_2, Y_1$ | $Z_{2,1}$ | $\cdots$ | | |
| $X_2, Y_2$ | $Z_{2,2}$ | $\cdots$ | | |
| $\vdots$ | $\vdots$ | $\cdots$ | | |
| $X_2, Y_h$ | $Z_{2,h}$ | $\cdots$ | | |
| $\vdots$ | $\vdots$ | $\cdots$ | | |
| $X_w, Y_h$ | $Z_{w,h}$ | $\cdots$ | | |

# FIG. 7

Z
DIRECTION

TOOTH WIDTH
DIRECTION
(X DIRECTION)

TOOTH HEIGHT
DIRECTION
(Y DIRECTION)

FIG. 8

**TOOTH SURFACE SHAPE DESIGN SUPPORT DEVICE**

| SAMPLE DATA GENERATION UNIT | ~4 |

| PRINCIPAL COMPONENT SHAPE DATA ACQUISITION UNIT | ~6 |

| TOOTH SURFACE SHAPE EVALUATION UNIT | ~8 |

| TOOTH SURFACE SHAPE DETERMINATION UNIT | ~10 |

| SYMMETRICAL TOOTH SURFACE SHAPE GENERATION UNIT | ~12 |

2

# FIG. 9

TOOTH WIDTH
DIRECTION
(X DIRECTION)

Z
DIRECTION

TOOTH HEIGHT
DIRECTION
(Y DIRECTION)

PRINCIPAL
COMPONENT $U_k$

M1

# FIG. 10

POSITION $Y_j$ IN TOOTH HEIGHT DIRECTION

POSITION $X_i$ IN TOOTH WIDTH DIRECTION

FIG. 11

- M2

Z
DIRECTION

TOOTH WIDTH
DIRECTION
(X DIRECTION)

TOOTH HEIGHT
DIRECTION
(Y DIRECTION)

PRINCIPAL
COMPONENT U$_k$

# FIG. 12

Z
DIRECTION

TOOTH WIDTH
DIRECTION
(X DIRECTION)

TOOTH HEIGHT
DIRECTION
(Y DIRECTION)

PRINCIPAL
COMPONENT $U_k$

M3

# FIG. 13

A1

A2

A3

TOOTH HEIGHT DIRECTION

TOOTH WIDTH DIRECTION

# FIG. 14A

THEORETICAL INVOLUTE
TOOTH SURFACE
(NO MODIFICATION)

TOOTH WIDTH DIRECTION

SHAPE AT POSITION A2 IN
TOOTH HEIGHT DIRECTION

SHAPE AT POSITION A1 IN
TOOTH HEIGHT DIRECTION

SHAPE AT POSITION A3 IN
TOOTH HEIGHT DIRECTION

# FIG. 14B

TOOTH
HEIGHT
DIRECTION

B1          B2          B3

TOOTH WIDTH DIRECTION

# FIG. 15A

SHAPE AT POSITION B2 IN TOOTH WIDTH DIRECTION

TOOTH
HEIGHT
DIRECTION

SHAPE AT
POSITION B1 IN
TOOTH WIDTH
DIRECTION

SHAPE AT POSITION B3 IN TOOTH WIDTH DIRECTION

# FIG. 15B

20

2

TOOTH SURFACE
SHAPE DESIGN
SUPPORT DEVICE

22

GEAR
MACHINING
MACHINE

GEAR
MEASURING
MACHINE

24

# FIG. 16

FIG. 17A

MESHING
ADVANCING
DIRECTION

MACHINED
PATTERN

# FIG. 17B

FIG. 18A

MACHINED PATTERN

MESHING ADVANCING DIRECTION

# FIG. 18B

Europäisches
Patentamt

European
Patent Office

Office européen
des brevets

# EUROPEAN SEARCH REPORT

Application Number

EP 21 17 2235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SHAO NAN ET AL: "Tolerance analysis of spur gears based on skin model shapes and a boundary element method", MECHANISM AND MACHINE THEORY, PERGAMON, AMSTERDAM, NL, vol. 144, 23 October 2019 (2019-10-23), XP085905676, ISSN: 0094-114X, DOI: 10.1016/J.MECHMACHTHEORY.2019.103658 [retrieved on 2019-10-23] | 1-3,7-10 | INV. F16H55/08 G06F30/17 F16H57/00 G01M13/021 G01M13/028 |
| A | * Sections 1, 2, 3.1, 3.2, 4.1, 4.2; figures 1,3 * ----- | 4-6 | |
| X | XU YUDONG ET AL: "Application of principal component analysis and BP neural network in gear noise prediction", COMPUTER ENGINEERING AND TECHNOLOGY (ICCET), 2010 2ND INTERNATIONAL CONFERENCE ON, IEEE, PISCATAWAY, NJ, USA, 16 April 2010 (2010-04-16), pages V5-251, XP031690213, ISBN: 978-1-4244-6347-3 | 1,2,10 | |
| | | | **TECHNICAL FIELDS SEARCHED (IPC)** |
| A | * the whole document * ----- | 3-9 | F16H G06F |
| A | JP 2010 164134 A (FUJI HEAVY IND LTD) 29 July 2010 (2010-07-29) * paragraph [0001]; claim 1; figures 1,2,7-9,17 * * paragraph [0004] - paragraph [0011] * * paragraph [0014] - paragraph [0026] * ----- | 7-9 | G01M |

The present search report has been drawn up for all claims

| Place of search | Date of completion of the search | Examiner |
|---|---|---|
| The Hague | 25 October 2021 | Foster, Keir |

EPO FORM 1503 03.82 (P04C01)

## ANNEX TO THE EUROPEAN SEARCH REPORT
## ON EUROPEAN PATENT APPLICATION NO.

EP 21 17 2235

This annex lists the patent family members relating to the patent documents cited in the above-mentioned European search report.
The members are as contained in the European Patent Office EDP file on
The European Patent Office is in no way liable for these particulars which are merely given for the purpose of information.

25-10-2021

| Patent document cited in search report | Publication date | Patent family member(s) | | Publication date |
|---|---|---|---|---|
| JP 2010164134 A | 29-07-2010 | JP | 5140007 B2 | 06-02-2013 |
| | | JP | 2010164134 A | 29-07-2010 |

EPO FORM P0459

For more details about this annex : see Official Journal of the European Patent Office, No. 12/82

**EP 3 916 267 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006242211 A